(19) Europäisches Patentamt
European Patent Office
Office européen des brevets

(11) **EP 0 405 812 B1**

(12) **EUROPEAN PATENT SPECIFICATION**

(45) Date of publication and mention
of the grant of the patent:
**27.08.1997 Bulletin 1997/35**

(51) Int Cl.6: **G11C 5/14**, G11C 8/00

(21) Application number: **90306608.2**

(22) Date of filing: **18.06.1990**

(54) **Driving circuit**

Treiberkreis

Circuit d'attaque

(84) Designated Contracting States:
**DE FR GB IT NL**

(30) Priority: **20.06.1989 JP 158757/89**

(43) Date of publication of application:
**02.01.1991 Bulletin 1991/01**

(73) Proprietor: **TEXAS INSTRUMENTS
INCORPORATED
Dallas Texas 75265 (US)**

(72) Inventors:
• **Inui, Takashi
Dallas, Texas 75252 (US)**
• **Sukegawa, Shunichi
Plano, Texas 75023 (US)**

(74) Representative: **Abbott, David John et al
Abel & Imray
Northumberland House
303-306 High Holborn
London, WC1V 7LH (GB)**

(56) References cited:
**EP-A- 0 167 275          DE-A- 3 710 821
US-A- 4 769 784**

**Description**

Background of the Invention

Field of the Invention

This invention concerns a driving circuit, such as a driving circuit suitable for driving the word lines, etc., in a dynamic RAM (Random Access Memory).

Description of the Prior Art

In conventional techniques of dynamic RAM design, the most important point is to increase the difference $\Delta V$ between the bit line voltage representing information "1" and that representing information "0." Assume that the bit line capacitance is $C_B$, the cell capacitance is $C_S$, the cell voltage with information "1" stored is $V_H$, and the cell voltage with information "0" stored is $V_L$, $\Delta V$ can then be represented as

$$\Delta V = \frac{V_H - V_L}{1 + C_B/C_S}$$

As can be seen from the above equation, one way to increase $\Delta V$ is to reduce the ratio $C_B/C_S$, which depends on the memory cell structure and the number of memory cells coupled to a single bit line. Another way is to increase the value of said $(V_H - V_L)$ in the circuit. However, $V_L$ (cell voltage for stored information "0") is usually 0V, while $V_H$ (cell voltage for stored information "1") depends on the voltage $V_{WL}$ when the word lines are open. Assume that the word line voltage $V_{WL}$ is set as power supply voltage $V_{DD}$, and the threshold voltage of the transfer gate of the memory cell is $V_T$ (WL), then

$$V_H = V_{DD} - V_T \text{ (WL)}$$

Hence, $V_H$ is lower than power supply voltage $V_{DD}$ by an amount equal to the threshold voltage (this, of course, decreases said value of $(V_H - V_L)$, making it impossible to increase the bit line voltage differences $\Delta V$). In order to solve this problem, various techniques related to circuits have been proposed to raise the word line voltage $V_{WL}$ higher than the power supply voltage $V_{DD}$ (i.e., $V_{WL} \geq V_{DD} + V_T(WL)$).

An increase in the said bit line voltage difference $\Delta V$ not only can increase the operating margin of the dynamic RAM, it is also effective in providing an improvement against so-called soft errors caused by $\alpha$-particles, etc.

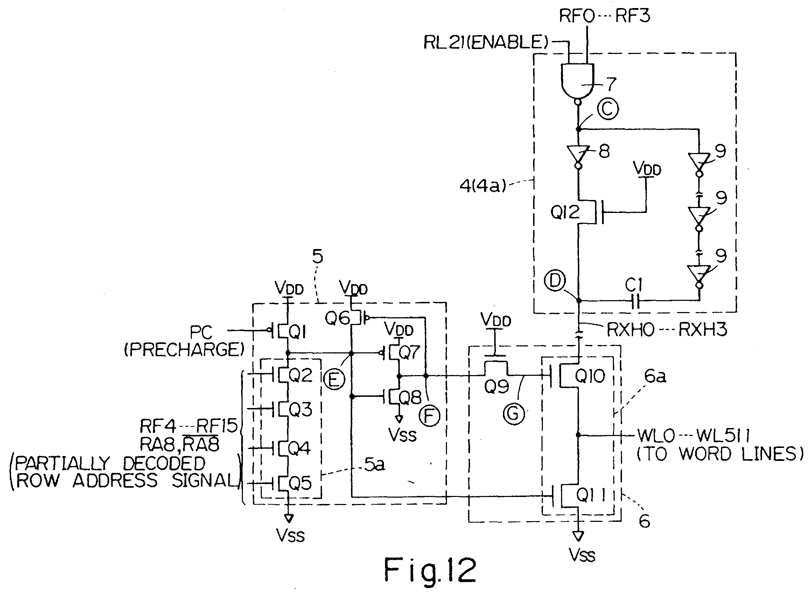

In the following, we will discuss the problems in an example of the conventional circuit technique for raising said word line voltage $V_{WL}$ to a level above the power supply voltage $V_{DD}$, with reference to Figures 12-17.

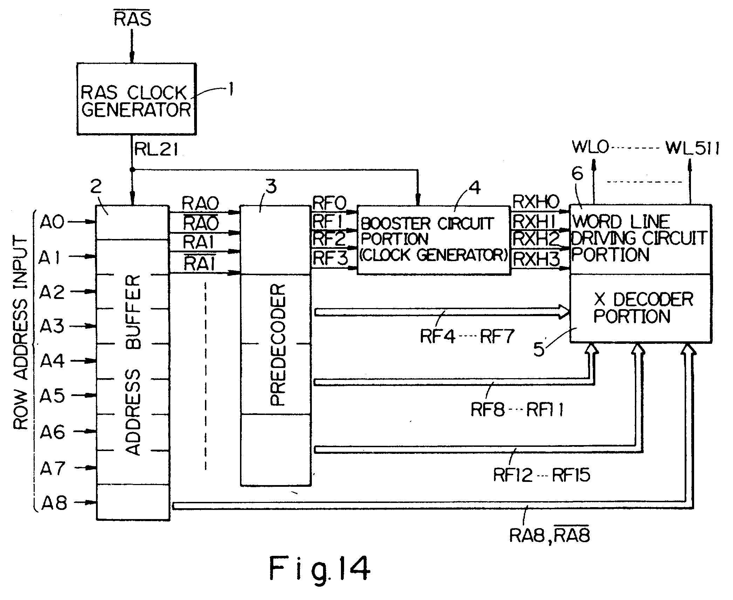

First of all, Figure 14 is a schematic block diagram of the circuit from $\overline{RAS}$ (Row Address Strobe) of, for example, a 1 M dynamic RAM to various word lines (for example, 512 lines). Its major operation mode can be explained as follows.

As shown in Figure 14, a clock signal (RL21) generated by RAS clock generator (1), for generating the operating clock of the RAS system upon the arrival of $\overline{RAS}$, controls address buffer (2) and booster circuit portion (4). At the falling edge of $\overline{RAS}$, address ($A_0$-$A_8$) is fetched by clock (RL21) into address buffer (2); the outputs of address buffer (2) (RA0, $\overline{RA0}$-RA7, RA7) are predecoded by predecoder (3). Among the outputs from the predecoder, the upper bits (RF4)-(RF15), RA8, and $\overline{RA8}$ are sent to X decoder portion (5); the lower bits (RF0)-(RF3) are sent to booster circuit portion (4), respectively, and used for control. At X decoder portion (5), each decoder is selected therewithin by the above RF4-RF15, RA8, and $\overline{RA8}$. Finally, with the aid of four clocks RXH0-RXH4 formed by booster circuit portion (4) and connected to word line driving circuit (6), one word line out of the 512 word lines (WL0-WL511) is selected.

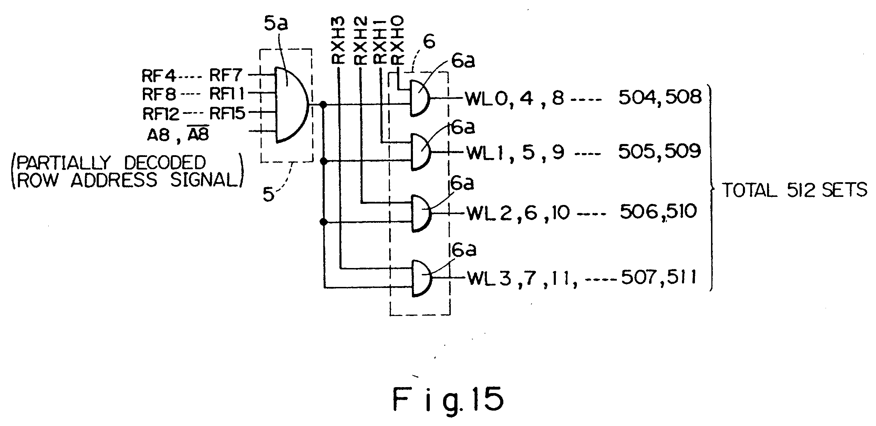

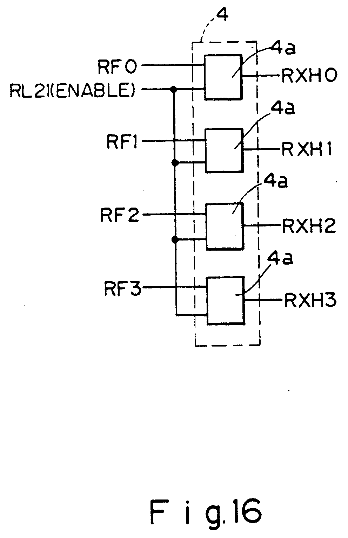

Figures 15 and 16 illustrate each connection relationship as well as operation of word line driving circuit portion (6), X decoder portion (5), and booster circuit portion (4) in Figure 14.

As shown in Figure 15, X decoder portion (5) is made of 4-input AND circuits, with a total number of 128 (4 x 4 x 4 x 2 = 128) said 4-input AND circuits (5a) being made of the various combinations of inputs RF4-RF7, RF8-RF11, RF12-RF15, RA8 and $\overline{RA8}$, respectively (only one 4-input AND circuit (5a) is shown in Figure 15 to simplify the explanation). The output of each said 4-input AND circuit (5a) is connected to one of the inputs of four 2-input AND circuits (6a) in word line driving circuit portion (6), respectively. The other inputs of these AND circuits (6a) are connected to RXH0-RXH3, output signals from booster circuit portion (4) as shown in Figure 14. The output of each of said four 2-input AND circuits (6a) is connected to four word lines (such as WL0-WL3). That is, in the circuit shown in Figure 15, each circuit group contains one 4-input AND circuit (5a) and four 2-input AND circuits (6a); for the said 4-input AND circuit (5a), there are 128 combinations of inputs; each of the 128 circuits has four word lines (such as WL0-WL3); hence, there are in total 512 word lines.

Selection of each of the word lines (WL0-WL511) in Figure 15 is performed as follows. For RF4-RF15, as explained above, depending on the predecoded address signal (A0-A7), among the four signals RF4-RF7, only one is set at level "1"; similarly, among RF8-RF11, only one is set at level "1"; among RF12-RF15, only one is set at level "1"; and among RA8 and $\overline{RA8}$, only one is set at level "1". On the other hand, among the four signals RXH0-RHX3 at booster circuit portion (4), only one is set at level "1"; hence, the total number of combinations is 128 X 4 = 512 (cases), and it is possible to select one out of 512 word lines (WL0-WL511).

As shown in Figure 16, booster circuit (4) consists of four identical circuit blocks (4a) (the internal circuit of which will be explained later with reference to Figure 12). Circuit blocks (4a) have said predecoded signals RF0-RF3 and signal RF21 from RAS clock generator (1) as their inputs, respectively. Circuit blocks (4a) output signals RXH0-RXH3, respectively. Signal RL21 connected to said booster circuit portion (4) is called a delayed function enable signal. Signal RL21 is used for determining the output timing of signals RXH0-RHX3. The time point determined by the output of said X decoder portion (5) (5a) is used as its timing.

In the following description, with reference to Figure 12, an example of the internal circuits of word driving circuit portion (6), booster circuit portion (4) and X decoder portion (5) will be presented together with an explanation of their operation. In order to facilitate the explanation, Figure 12 only depicts a part of the major configurations of the internal circuits.

With regard to X decoder portion (5) shown in Figure 12, four N-channel MOS transistors Q2-Q5 are connected to each other with the drains of respective transistors being connected to the source of the adjacent transistor. The source of transistor Q5 is connected to ground $V_{SS}$. The drain of transistor Q2 is connected to the drain of P-channel MOS transistor Q1. In addition, the source of transistor Q1 is connected to power supply $V_{DD}$. The gate of transistor Q1 is connected to precharge signal PC. Gates of transistors Q2-Q5 are connected to said signal inputs RF4-RF15, RA8 and $\overline{RA8}$, respectively (i.e., said transistors Q2-Q5 form said 4-input AND circuit 5a).

In addition, the drain of P-channel MOS transistor Q1 (or the source of N-channel MOS transistor Q2) is connected to the drain of P-channel MOS transistor Q6 and the gates of P-channel MOS transistor Q7 and N-channel MOS transistors Q8 and Q11, respectively. The source of transistor Q6 and the drain of transistor Q7 are connected to power supply $V_{DD}$, respectively. The source of transistor Q8 is connected to ground $V_{SS}$; the drains of transistors Q7 and Q8 are connected with each other; their drains are connected to the gate of transistor Q6 and the drain of N-channel MOS transistor Q9 in word line driving circuit portion (6) to be described later, respectively.

In Figure 15, in order to facilitate explanation, the explanation is omitted for the portions corresponding to the circuit configurations of said transistors Q6, Q7, and Q8.

Now, with regard to word line driving circuit portion (6), the 2-input AND circuit (6a) is made of two N-channel MOS transistors Q10 and Q11. That is, the source of transistor Q10 and the drain of transistor Q11 are connected to each other; the source of transistor Q10 is connected to outputs RXH0-RXH3 of booster circuit portion (4); the source of transistor Q11 is connected to ground $V_{SS}$. The gate of transistor Q9 is connected to power supply $V_{DD}$; its source is connected to the gate of transistor Q10. The source of transistor Q10 (or the drain of transistor Q11) is connected to word lines WL0-WL511. The explanation is omitted for the portions corresponding to the circuit configurations of said transistor Q9 and Q10 in Figure 15 to simplify the explanation.

Explanation will follow with regard to Figure 12 for one circuit block (4a) of the booster circuit portion (4) in Figure 16. Clock RL21 and RF0-RF3 are connected to the inputs of 2-input NAND gate (7). Its output is connected via inverter (8) to the drain of N-channel MOS transistor Q12, and via three inverters (9) (in this example, the 3 inverters form a delay circuit) and capacitor (C1) to the drain of transistor Q10. Besides, the gate of transistor Q12 is connected to power supply $V_{DD}$, and its source is connected to the drain of transistor Q10.

In order to produce output clock signals RXH0-RXH3 in the booster circuit portion (4), node (D) is first charged to voltage $V_{DD} - V_T$, which is lower than the power supply voltage by $V_T$, the threshold voltage of N-channel MOS transistor Q12, with node (C) being at level "L". The voltage at node (D) is increased due to capacitive coupling via capacitor CI with a time difference caused by inverters (9). RF0-RF3 and RL21 (enable) play the role of controlling timing of word line driving circuit portion (6) to be explained later. They also play the role of a decoder by selecting one out of the said four word lines (one out of WL0-WL3 in the example shown in Figure 15).

In the following, an example with specific values of voltage levels for the major operation process of Figure 12 will be described. First, in the precharge state, the precharge signal PC at the input of the gate of P-channel MOS transistor Q1 becomes level "0"; the partially decoded row address signals (RF4-RF15, RA8, and $\overline{RA8}$ in Figure 14) set all the gates of N-channel MOS transistors (Q2)-(Q5) to level "0." Hence, transistors Q2-Q5 are all in the OFF state, and transistor Q1 is in the ON state, such that the voltage at the node (E) increases to 5 V ($V_{DD}$).

P-channel MOS transistor Q6 latches said node (E) at the 5 V state. Node (E) is kept at 5 V even when the precharge signal PC disappears (i.e., even when precharge signal PC becomes level "1" and transistor Q1 is turned OFF, transistor Q6 is in the ON state due to the level "0" output of the inverter made of transistors Q7 and Q8; hence, node (E) is maintained at 5 V). In this case, nodes (F) and (G) are at 0 V ($V_{SS}$), and all of the word lines (WL0-WL511) are also at 0 V, since N-channel MOS transistor Q11 is in the ON state.

Then, when the operation state occurs, the partially decoded row address signals (RF4-RF15, RA8, and $\overline{RA8}$) set level "1" for all the gates of transistors Q2-Q5; hence, they all turn to the ON state. Therefore, node (E) is charged to 0 V contrary to the above operation; furthermore, because of transistor Q9 (this transistor Q9 is always in the ON state because its gate is connected to the power supply voltage $V_{DD}$), the voltage at node (G) falls by the threshold voltage $V_T$ (1 V) of transistor Q9 to be charged to 4 V. After charging is finished, transistor Q9 is turned OFF; hence, node (G) is in a floating state.

By raising one of RXH0-RXH3 from 0 V to 5 V, with node (G) being charged to 4 V, node (G) is so-called, self-booted (self step-up) by transistor Q10 to be charged to about 8 V. With regard to the said self-boot phenomenon, when node (G) is at 4 V, and RXH0-RXH3 as well as each word line (WL0-WL511) is at 0 V, transistor Q10 is ON; equivalently, node (G) may be regarded as being connected to RXH0-RXH3 and word lines (WL0-WL511) with a capacitor therebetween. The capacitor has a capacitance equal to the gate capacitance of transistor Q10 in the ON state. In this case, when one of RXH0-RXH3 is changed from 0 V to 5 V, the voltage at node (G) increases due to the capacitance of the said capacitor (the gate capacitance of transistor Q10). Ideally, it should be increased by 5 V. However, in the actual situation, due to the charge share with the self-capacitance of node (G) (wire capacitance of node (G), the capacitance of diffusion layer of transistor Q6, etc.), the voltage increase cannot reach 5 V and is usually about 3-4 V.

As explained above, as node (G) is boosted to a voltage of about 8 V, the 5 V voltage can be transmitted from RXH0-RXH3 to the word line (for example, WL0) with the aid of transistor Q10. When data are refreshed (rewritten) in the dynamic RAM, word line boosting circuit portion (4) boosts RXH0-RXH3 from 5 V to 8 V, and boosts node (G) to about 12 V; hence, the word line (for example, WL0) is further charged to 8 V. Besides, as explained above, in X decoder portion (5) in Figure 14, each decoder is connected to four word lines (such as, WL0-WL3). Among these lines, only one (for example, WL0) is finally selected through word line driving circuit portion (4) (see Figures 14-16).

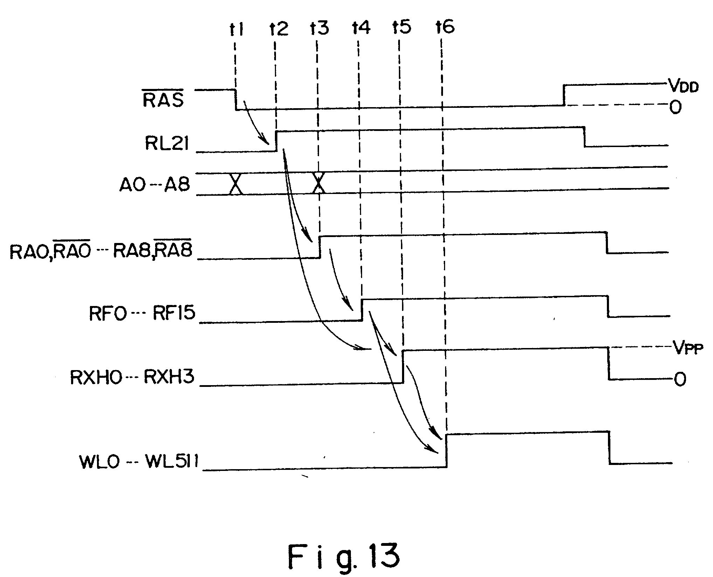

Now, with reference to Figures 13 and 14, described below is the major operation before a high-voltage output $V_{PP}$ (for example, 8 V) from booster circuit portion (4) is output to the word line selected by the input signal of the $\overline{RAS}$ system shown in Figure 14 as described above.

First, with $\overline{RAS}$ being at level "0" at time $t_1$, signal RL21 which is provided by RAS clock generator (1) becomes level "1" at time $t_2$ and is entered into address buffer (2). Due to signal RL21, at time $t_3$, row address inputs A0-A8 are taken into address buffer (2); at the same time, output signals RA0, $\overline{RA0}$-RA7, and $\overline{RA7}$ from address buffer (2) are taken into predecoder (3); and RA8 and $\overline{RA8}$ are each taken into X decoder portion (5).

Then at time $t_4$, signals RF0-RF3 predecoded at predecoder (3) are taken into booster circuit portion (4), while RF4-RF15 are taken into X decoder portion (5). At time $t_5$, output signals RXH0-RXH3 from booster circuit portion (4) and signals RF4-RF15, RA8, and $\overline{RA8}$ input into the X decoder (5) select, as described above, a word line (for example, WL0) which acquires a high-voltage output $V_{PP}$ (for example, 8 V) at time $t_6$ through word line driving circuit portion (6).

As explained above, in the dynamic RAM, X decoder portion (5), word line driving circuit portion (6), and booster circuit portion (4) form the driving circuit. As explained above with reference in Figure 12, in the word line driving circuit portion (6) within the said driving circuit, because N-channel MOS transistor Q10 has to transfer the levels (voltages) of RXH0-RXH3 by self-boot operation, the timing of the operation of node (E) and RXH0-RXH3 must be controlled. That is, the signals must be controlled to ensure the following relationship: after node (E) reaches level "0" (0 V) and node (G) reaches $V_{DD}$ - $V_T$ (about 4 V) which is lower than the power supply voltage by threshold voltage $V_T$ of transistor Q9, RXH0-RXH3 rise. In this case, the necessity for performing timing control (or, control of sequence) in the said self-boot (self-step-up) operation is as follows: when the voltages at nodes (F) and (G) are lower than $V_{DD}$ - $V_T$, i.e., $VDD - V_T > V_F$ (voltage of node (F)), a prescribed voltage (for example, 5 V) enters transistor Q10 due to RXH0-RXH3; an attempt to raise node (G) by coupling of the gate capacitance of transistor Q9 only results in the electric charge escaping to node (F) through the channel of transistor Q9.

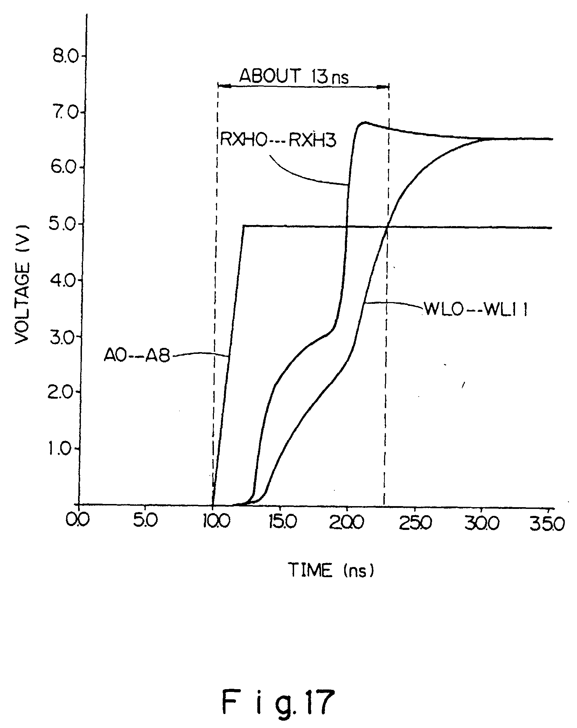

As explained above, if signals RXH0-RXH3 are not raised in a timing after transistor Q9 is pinched off (i.e., the state in which the charge cannot leak from node (G) to (F) with the voltage of node (G) being $V_{DD}$ - $V_T$ (about 4 V), the self-boot operation due to the gate capacitance of transistor Q10 could not be performed. As explained above with reference to Figures 13 and 14, because the timing of output signals RXH0-RXH3 from word line driving circuit portion (4) has to be controlled sequentially according to row address inputs (A0-A8) taken due to signals of $\overline{RAS}$ and RL21, to provide a high-voltage output $V_{PP}$ (for example, 8 V) to the selected word line (for example, WL0) takes a very long time. Actually, as shown in Figure 17, after row address input (A0-A8) is taken, it takes about 13 ns before one of the word lines (WL0-WL511) reaches 5 V. (As a matter of fact, if the margin of the power supply voltage $V_{DD}$ and the temperature margin are taken into consideration, a longer time will be needed. This is a serious problem in realizing high-speed operation of a dynamic RAM, etc.

EP-A-0 167 275 discloses a semiconductor memory device having a driving signal output circuit (TR) which drives an output line (WL0) under the control of an operation signal supply circuit ($WD_o$). The driving signal output circuit in realised - like all components of this bipolar type semiconductor memory device - in the form of a bipolar transistor.

An object of this invention is to provide a type of driving circuit that can output driving signals with a predetermined voltage in a short time to output lines, such as word lines or the like, in a dynamic RAM.

According to the present invention there is provided a driving circuit comprising:

an operation signal supply circuit for receiving an input signal and having an output to provide an operation signal as an output signal,

a power supply source from which a first predetermined voltage is provided as an output,

a booster circuit for providing a second predetermined voltage higher than said first predetermined voltage as an output,

a driving signal output circuit respectively connected to the outputs of said operation signal supply circuit and said booster circuit, said driving signal output circuit including series connected first and second transistors having respective control gates, said first and second transistors being operated in a fashion that the one thereof is conductive when the other thereof is non-conductive,

the output of said operation signal supply circuit being connected to the control gates of said first and second transistors,

an output line connected to a node located between said first and second transistors,

a control MOS transistor interposed in the connection between said power supply source and said operation signal supply circuit, said control MOS transistor having source and drain regions and a gate electrode, and

said control MOS transistor being responsive to a precharged signal applied to the gate electrode thereof for transmitting said first predetermined voltage from said power supply source to the control gates of said first and second transistors included in said driving signal output circuit;

characterized in that said first and second transistors of said driving signal output circuit are respectively

a bipolar transistor as the first transistor and having base, collector and emitter electrodes,

an MOS transistor as the second transistor and having source and drain regions and a gate electrode,

one of the collector electrode and the emitter electrode of said bipolar transistor being connected to one of the source region and the drain region of said MOS transistor,

the other of the collector electrode and the emitter electrode of said bipolar transistor being connected to the output of said booster circuit,

the other of the source region and the drain region of said MOS transistor being connected to a reference potential,

said bipolar transistor when conductive transmitting said second predetermined voltage as provided by said booster circuit less the voltage drop across the conductive bipolar transistor to said output line as a boosted drive voltage higher than said first predetermined voltage provided by said power supply source while said MOS transistor is non-conductive, and

said bipolar transistor when non-conductive preventing the application of the output of said booster circuit to said output line, while said MOS transistor is conductive for connection to the reference potential.-

## Brief Explanation of the Figures

Figures 1-11 illustrate embodiments of this invention.

Figure 1 is an equivalent circuit diagram showing an embodiment in which this invention is applied to a dynamic RAM.

Figure 2 is a timing chart illustrating the major operations in Figure 1 and in Figure 3, to be described later.

Figure 3 is a schematic block diagram illustrating the major configuration of a dynamic RAM to which the embodiment shown in Figure 1 is applied.

Figure 4 is an equivalent circuit diagram of the logic gates for illustrating the connection relation of actual X decoder portion (25), word line driving circuit portion (26) and booster circuit portion (24).

Figure 5 shows the actual voltage-time characteristic in the embodiment shown in Figure 1.

Figure 6 is a cross-sectional diagram illustrating the major device configuration in Figure 1 (cross-sectional diagram of Figure 7 cut along the VI-VI line).

Figure 7 is a plan view of Figure 6.

Figure 8 is an equivalent circuit diagram illustrating another embodiment of this invention.

Figure 9 is an equivalent circuit diagram illustrating another embodiment of this invention.

Figure 10 is an equivalent circuit diagram illustrating another embodiment of this invention.

Figure 11 is an equivalent circuit diagram illustrating yet another embodiment of this invention.

Figures 12-17 illustrate a conventional embodiment.

Figure 12 is an equivalent circuit diagram illustrating a conventional driving circuit.

Figure 13 is a timing chart illustrating the major operations in Figures 12 and 14.

Figure 14 is a schematic block diagram illustrating the main configuration of the dynamic RAM to which the driving circuit shown in Figure 12 is applied.

Figure 15 is an equivalent circuit diagram of the logic gates illustrating the connection relation of X decoder (5), word line driving circuit portion (6) and booster circuit portion (4) in Figure 12.

Figure 16 is a schematic block diagram illustrating the connection relation of the circuit configuration of booster circuit portion (4) in Figure 12.

Figure 17 shows the actual voltage-time characteristic in the embodiment shown in Figure 12.

The reference numerals used in the figures are as follows:

| | |
|---|---|
| 1 | RAS clock generator; |
| 2 | Address buffer; |
| 3 | Predecoder; |
| 4. 25 | Booster circuit portion (voltage supply circuit portion); |
| 5, 25 | X decoder portion (operation signal supply circuit portion; |
| 6, 26 | Word line driving circuit portion (driving signal output circuit portion); |
| N1, N2, N3, N4, N5, N6, N7, N8, Q2, Q3, Q4, Q5, Q8, Q9, Q10, Q11, Q12 | N-channel MOS transistors; |
| P1, P2, P3, Q1, Q6, Q7 | P-channel MOS transistors; |
| BN1 | NPN bipolar transistor; |
| BP1 | PNP bipolar transistor; |
| A0, A1, A2, A3, A4, A5, A6, A7, A8 | Address input; |
| WL0-WL511 | Word lines; |
| RXH, RXH0, RXH1, RXH2, RXH3 | Predetermined voltage output signal; |
| $V_{PP}$ | High-voltage output; |
| $V_{DD}$ | Power supply side; and |
| $V_{SS}$ | Ground side. |

## Application Examples

In the following, this invention will be explained with reference to the embodiments.

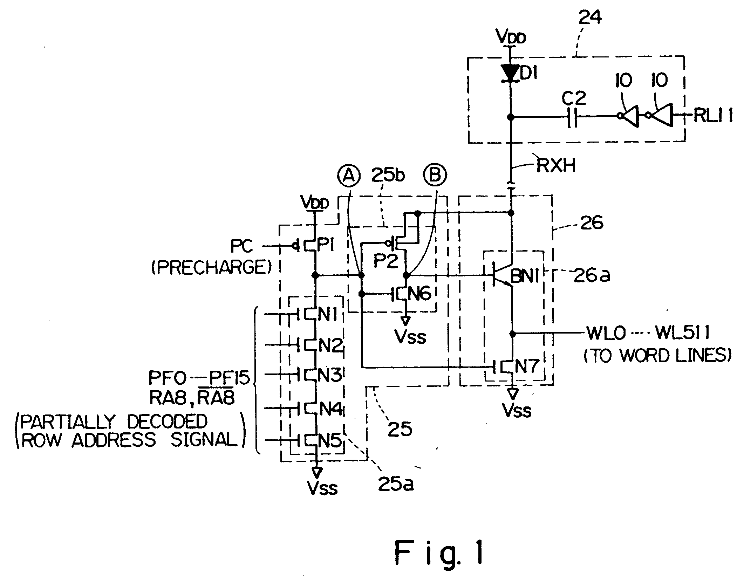

Figures 1-7 illustrate an example of this invention applied to a 1 M dynamic RAM. Like reference characters are used for like and corresponding parts, and an explanation of which may be omitted.

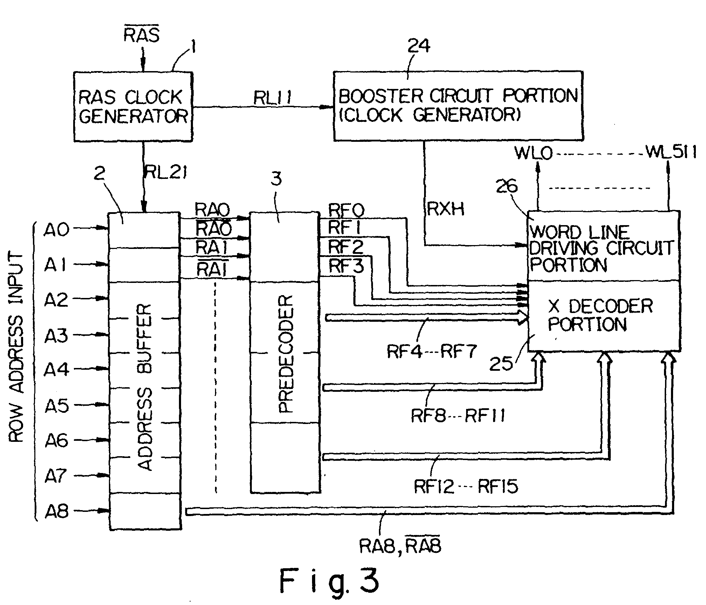

Figure 3 is a schematic block diagram illustrating the structure from $\overline{RAS}$ to the word lines (such as the 512 lines of WL0-WL511). The structure is roughly identical to the example illustrated in Figure 14. The difference is that output signals RF0-RF3 from predecoder (3) are each connected to X-decoder portion (25); a signal RL11 generated by RAS clock generator (1) in addition to RL21 is connected to booster circuit portion (24); and the output signal RXH is connected to word line driving circuit portion (26).

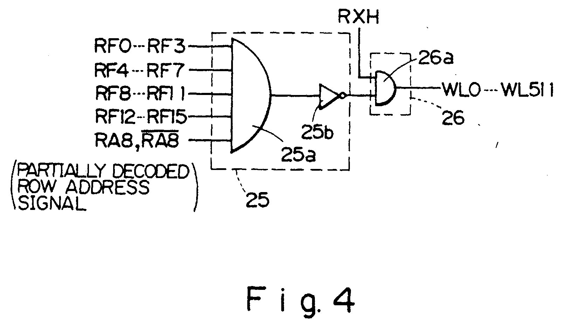

Figure 4 illustrates the wiring relation between word line driving circuit portion (26) and X decoder portion (25). Their operations can be explained as follows. As shown in Figure 4, X decoder portion (25) comprises a 5-input AND circuit (25a) and an inverter (25b); word line driving circuit portion (26) comprises a 2-input AND circuit (26a). The output of the inverter (25b) in the X decoder portion (25) is connected to one of the two inputs of the 2-input AND gate (26a) in word line driving circuit portion (26). The output signal RXH from the booster circuit portion (24) is connected to the other input of the AND circuit. The output of the 2-input AND circuit (26a) is connected to one of the various word lines (WL0-WL511).

That is, there are a total of 512 circuits comprising the 5-input AND circuit (25a), the inverter (25b) and the 2-input AND circuit (26a) with $4 \times 4 \times 4 \times 4 \times 2 = 512$ combinations of the inputs RF0-RF3, RF4-RF7, RF8-RF11, RF12-RF15, RA8, and $\overline{RA8}$ entered into the 5-input AND circuit (25a). Each of the 512 circuits is connected to one word line in the configuration. The operation is similar to the selection of each word line (WL0-WL511) by the X decoder portion (5) in the aforementioned example. In this case, however, as will be explained later, each word line (WL0-WL511) is structured only to be selected by output signals RF0-RF15, RA8, and $\overline{RA8}$ from predecoder (3) in Figure 3.

Figure 1 shows a specific example of the internal circuits of word line driving circuit portion (26), booster circuit portion (24), and X decoder portion (25) to illustrate the operation.

First, with regard to X decoder portion (25) shown in Figure 1, the circuit configuration is similar to that in the example shown in Figure 12. That is, P-channel MOS transistors P1 and P2 in this case correspond to P-channel MOS transistors Q1 and Q7 in Figure 12; N-channel MOS transistors N2-N5 and N6 correspond to N-channel MOS transistors Q2-Q5 and Q8 in Figure 12, respectively. With regard to differences therefrom, N-channel MOS transistor NI is connected between P-channel MOS transistor P1 and N-channel MOS transistor N2; the substrate (N-well (13) to be described later) of P-channel MOS transistor P2 is connected to its source, and they are further connected to output signal RXH of booster circuit portion (24). In this example, there is no transistor corresponding to P-channel MOS transistor Q6 shown in Figure 12. Hence, as explained above, in X decoder portion (25), transistors N1-N5 form 5-input AND circuit (25a) shown in Figure 4; transistors P2 and N6 form inverter circuit (25b) shown in Figure 4.

Now, with regard to word line driving circuit portion (26), compared to the example shown in Figure 12, N-channel MOS transistor N7 corresponds to transistor Q11 in Figure 12; NPN bipolar transistor BN1 corresponds to transistor Q10 shown in Figure 12. However, in this example, there is no transistor corresponding to transistor Q9 in Figure 12. As to the connection of each element, the base of NPN bipolar transistor BN1 is connected to the drains of P-channel MOS transistor P2 and N-channel MOS transistor N6; the collector of transistor BN1 is connected to the source of P-channel MOS transistor P2 and output signal RXH from booster circuit portion (24); and the emitter of transistor BN1 is connected to word lines (WL1-WL511) and the drain of N-channel MOS transistor $N_7$. Hence, as explained above, in word line driving circuit portion (26), NPN bipolar transistor BN1 forms 2-input AND circuit (26a) shown in Figure 4. This NPN bipolar transistor BN1 and N-channel MOS transistor N7 connected to the ground side $V_{SS}$ form the basic circuit structure thereof.

Now, with regard to the most basic configuration of booster circuit portion (24), signal RL11 generated by RAS clock generator (1) in Figure 3 is connected to the cathode of diode D1 via two inverters (10) and capacitor (C2) for boosting; the anode of diode D1 is connected to power supply voltage $V_{DD}$; its cathode outputs output signal RXH. The operation of this portion is as follows: as shown in Figure 3, when $\overline{RAS}$ becomes level "1," RXH becomes $V_{DD}$ - VD1 (the level after the drop of the voltage by a single stage of diode D1: about $V_{DD}$ - 0.7 V). When $\overline{RAS}$ falls (to level "0"), RL11 becomes level "1," and due to boosting capacitor C2, output RXH is boosted to $V_{PP}$ (about 8 V when $V_{DD}$ equals 5 V). Until RL11 becomes level "1" and boosting is performed due to capacitor C2, RXH remains at the level of $V_{DD}$ - $V_{D1}$) and does not become level "0."

The overall basic operation of the circuit configuration shown in Figure 1 is similar to that in the example shown in Figure 12. The difference is the following: if node (A) is at level "0," the level of RXH is transmitted directly to node (B) through P-channel MOS transistor P2; thus, at that time, the predetermined voltage (for example, $V_{PP}$ - $V_{BE}$) when the base-emitter voltage of transistor BN1 is $V_{BE}$) can be transmitted to a selected word line (for example, WL0) by output signal RXH of booster circuit portion (24) through NPN bipolar transistor BN1.

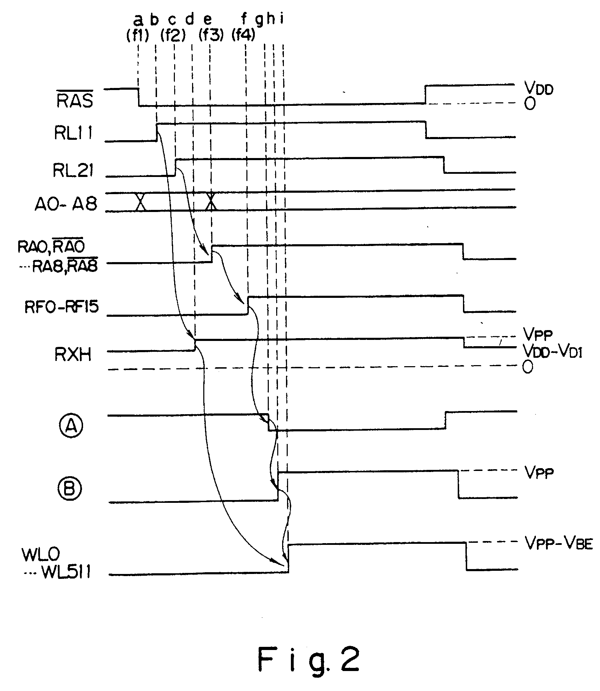

In the following, with reference to Figure 2, the major operations of providing a high-voltage output ($V_{PP}$ - $V_{BE}$) from booster circuit (24) to the word line selected by the above $\overline{RAS}$ signal input in Figure 3 will be described.

First of all, the major operations at time points a-f in Figure 2 are similar to the operations at time points $t_1$-$t_4$ as explained above with respect to Figure 13. (That is, time points a, c, e, and f in this case correspond to time points $t_1$, $t_2$, $t_3$, and $t_4$ in Figure 13, respectively.) The differences are that at time point b, signal RL11 becomes level "1" ($V_{DD}$), and at a later time point d, signal RXH becomes $V_{PP}$ (for example, 8 V).

At time point g, node (A) shown in Figure 1 becomes level "0" ($V_{SS}$). At a later time point h, the voltage at node (B) is raised to $V_{PP}$ Then, immediately at time point i, as explained above, the selected word line (for example, WL0) is charged to ($V_{PP}$ - $V_{BE}$) by signal RXH through NPN bipolar transistor BN1.

As explained above, in this example, the driving circuit comprises X-decoder portion (25), word line driving circuit portion (26) which receives the output signal of X decoder (25) to output a driving signal (such as $V_{PP}$ - $V_{BE}$ in this example) to the selected word line, and a booster circuit portion (24) which provides a predetermined voltage (such as $V_{PP}$ (8 V)) to word line driving circuit portion (26) to form the driving signal; an NPN bipolar transistor BN1 is set on the booster circuit portion (24) side of the word line driving circuit portion (26); this NPN bipolar transistor BN1 is operated by the output signal of the X decoder portion (25) and outputs the predetermined voltage of the booster circuit portion (24) to the word line as the driving signal. As a result, there is no need to perform the self-boot (self-step-up) operation in word line driving circuit portion (6) as required for the conventional driving circuit shown in Figure 12.

Consequently, there is no need to provide for control of the timing for performing the self-boot (self-step-up) operation. (That is, in this example, as explained above, in the stage in which signal RL11 enters the booster circuit portion (24), due to the output signal RXH of booster circuit portion (24), the base of NPN bipolar transistor BN1 may be maintained at a high voltage $V_{PP}$.) As a result, as explained above, there is no need to control the timing of X decoder portion (25) and word line driving circuit portion (26) for forming signal RXH at booster circuit portion (24) and operating X decoder portion (25). (As explained above, X decoder portion (25) is sequentially controlled by RAS (RL21) and row address input A0-A8) in a parallel way (i.e., performing this operation separately). As a result, the time needed to control the timing can be shortened; thus, the predetermined voltage can be output to the selected word line (for example, WL0) in a short time.

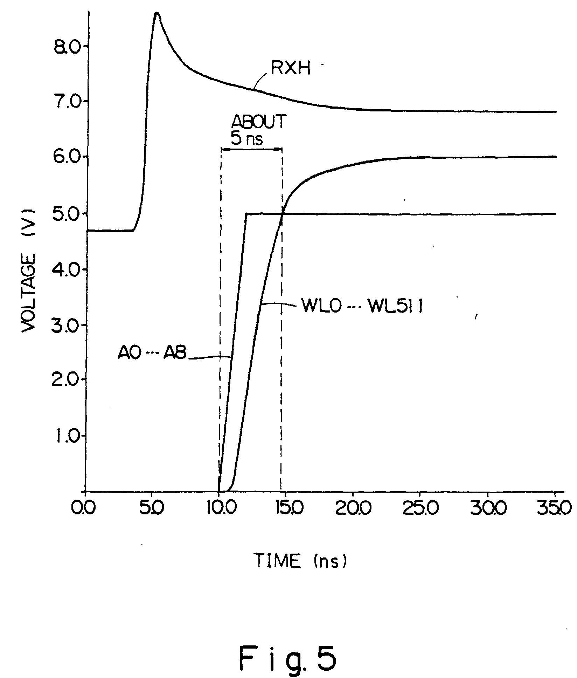

As shown in Figure 5, in the actual operation, after row address input A0-A8 is taken into address buffer (2) by signal RL21, in a very short time of about 5 ns, the selected word line (for example, WL0) can be raised to 5 V. On the other hand, as pointed out above, in the conventional example, about 13 ns is needed to raise the selected word line (for example, WL0) to the same voltage of 5 V.

Besides, as explained above, in this example, an NPN bipolar transistor BN1 is set on the booster circuit portion (24) side of word line driving circuit portion (26) (in this example, between word line and booster circuit portion (24)); hence, the high-speed operation ability of NPN bipolar transistor BN1 itself is very favorable for the said advantages.

In addition, in this example, there is no need to have extra circuit components for controlling the timing of output signal RXH in booster circuit portion (24) as in conventional booster circuit portion (4) shown in Figure 12; hence, the circuit configuration can be simpler than the conventional one.

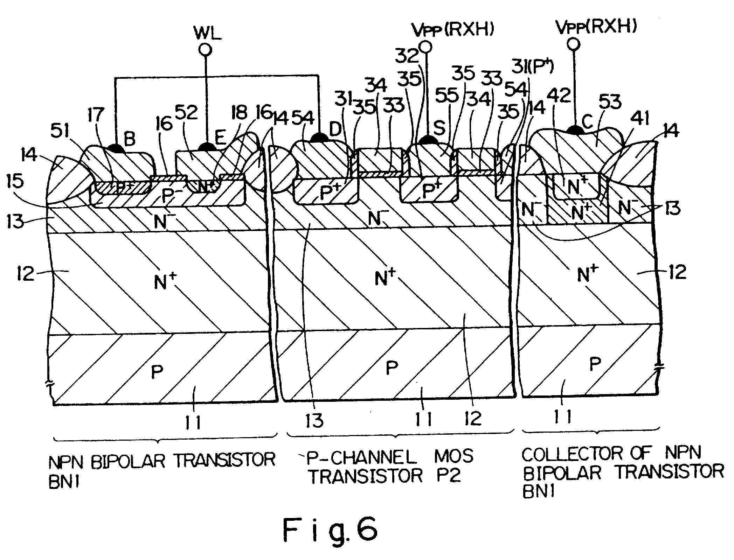

Figure 6 shows an example of the device structure of NPN bipolar transistor BN1, P-channel MOS transistor P2, etc., shown in Figure 1.

First of all, with regard to NPN bipolar transistor BN1, an $N^-$-type diffusion layer (N-well) (13) is formed over a surface of a P-type silicon substrate (11) with an $N^+$-type buried layer therebetween. A $P^-$-type base region (15) is formed in this $N^-$-type diffusion layer (13). In $P^-$-type base region (15), a $P^+$-type base electrode contact region (17) and an $N^+$-type emitter region (18) are formed by diffusion, respectively. On a portion of $N^+$-type buried layer (12) where above each region is not formed, an $N^+$-type diffusion region (41) is formed; furthermore, an $N^+$-type collector electrode contact region (42) is formed therein. Hence, for the NPN-type vertical bipolar transistor BN1, $N^+$-type collector contact region (42) and $P^-$-type base region (15) are connected with each other via $N^-$-type diffusion region (13), $N^+$-type buried layer (12), and $N^+$-type diffusion region (41).

Besides, in this figure, (14) is a field oxide film, (16) is an oxide film, (51) is a base electrode, (52) is an emitter electrode, and (53) is a collector electrode.

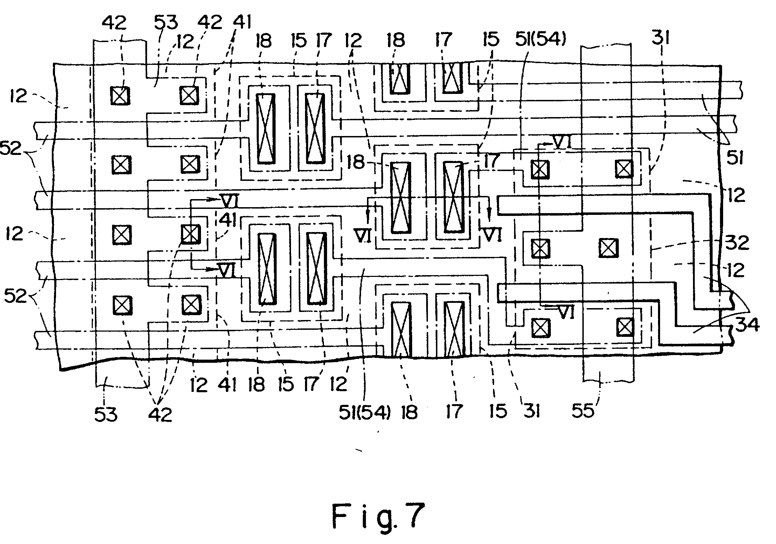

Now, with regard to P-channel MOS transistor P2, on the surface of $N^-$-type diffusion layer (13), a $P^+$-type drain region (31) and a $P^+$-type source region (32) are formed with predetermined patterns, between which a gate electrode (34) is formed with a gate oxide film (33) therebetween to form the P-channel MOS transistor P2. In this figure, (54) is a drain electrode, and (55) is a source electrode. Figure 7 is a plan view of Figure 6. Figure 6 is a cross-sectional view of Figure 7 cut along the VI-VI line.

As explained above, in this example, $N^+$-type buried layer (12) and $N^-$-type diffusion layer (N-well) (13) are used as the collector region of NPN bipolar transistor BN1. In addition, the common $N^-$-type diffusion layer (N-well) (13) is used to form the P-channel MOS transistor P2 with the so-called bi-MOS technique (a combination of the bipolar technique and the MOS technique). As a result, because of the device structure, the area occupied by elements is smaller than that occupied by the conventional circuit configuration of simple MOS transistors shown in Figure 12. This is very advantageous for minimizing devices.

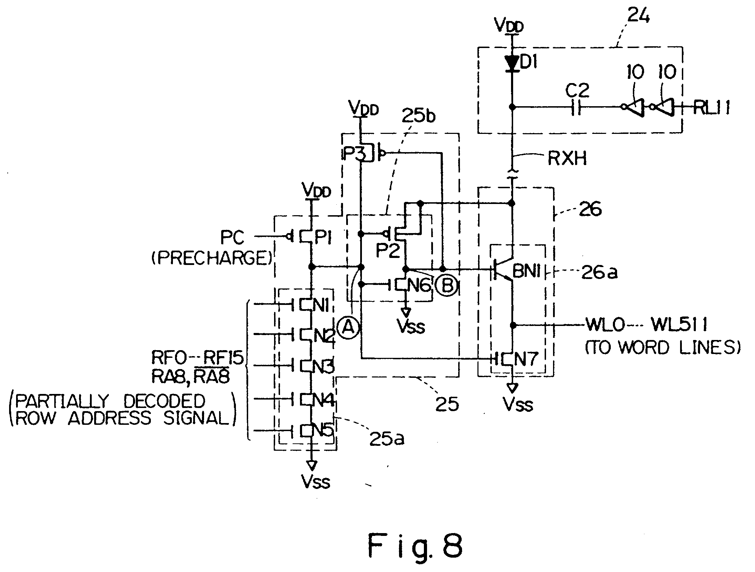

Figure 8 illustrates another example of this invention. The basic circuit configuration is similar to that of the example shown in Figure 1; hence, the explanation will be omitted for the identical portions. The difference is that P-channel MOS transistor P3 corresponding to P-channel MOS transistor Q6 in Figure 12 is located between node (A) and node (B). That is, the source of P-channel MOS transistor P3 is connected to the power supply voltage $V_{DD}$; its drain is connected to the gates of P-channel MOS transistor P2 and N-channel MOS transistor N6; and the gate of this transistor P3 is connected to the drains of P-channel MOS transistor P2 and N-channel MOS transistor N6.

As explained above, in this example, even though there is no precharge signal PC as in the example shown in Figure 12, node (A) can still be kept at $V_{DD}$ (for example, 5 V), which is favorable for the stable operation of the circuit.

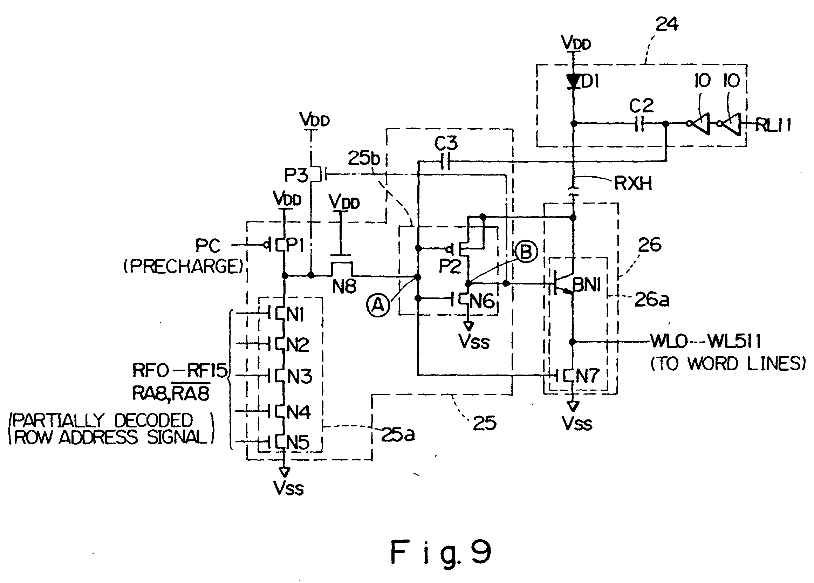

Figure 9 shows yet another example of this invention. Instead of P-channel MOS transistor P3 in Figure 8, N-channel MOS transistor N8 is used in this example, with its gate connected to power supply voltage $V_{DD}$, its drain connected to the drain of P-channel MOS transistor P1, and its source connected to node (A). Transistor N8 is used for isolation and is turned off when the source voltage beomes $V_{DD} - V_T$. At this time, the drain and source are isolated (floating state), and the voltage at node (A) can be maintained.

Besides, in this example, a capacitor C3 is connected between node (A) and the output of two inverters (10) in booster circuit portion (24). That is, in the unselected state, with the signal RXH being increased to $(V_{DD} + V_T)$ and above, and with node (A) being in the state of $V_{DD}$ (actually, $V_{DD} - V_T$ in this example), P-channel MOS transistor P2 will be turned ON which causes an error operation as the predetermined voltage is provided to a word line which is not selected); however, by providing the capacitor C3, in the unselected state, signal RL11 boosts the gate voltage (to $V_{DD} + V_T$ and above) of P-channel MOS transistor P2, so that transistor P2 cannot be turned ON. Besides, as shown by the broken lines in Figure 9, a P-channel MOS transistor P3 may also be provided as in the example shown in Figure 8.

As explained above, this example has the same advantages as the preceding examples, and is thus advantageous for improving the reliability of circuit operation.

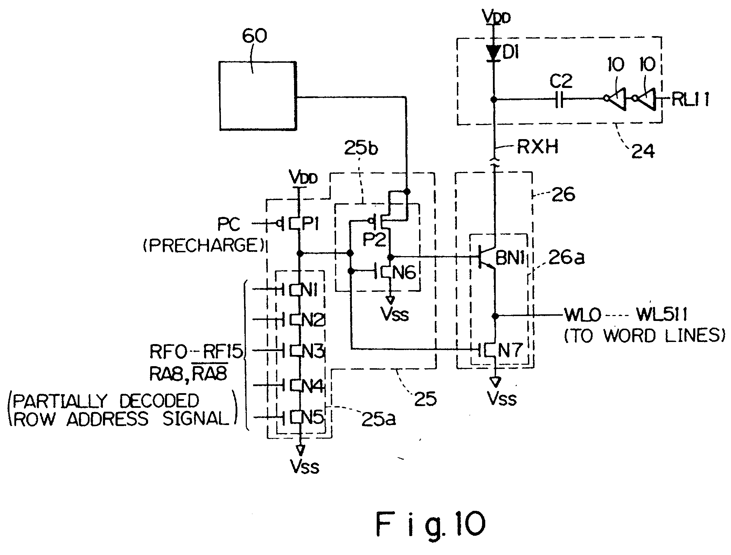

Figure 10 shows yet another application example of this invention. The basic circuit configuration is similar to that of the preceding examples, and the explanation of the same portions will be omitted. The difference is that the source of P-channel MOS transistor P2 is not connected to output signal RXH of booster circuit portion (24); instead, another booster circuit portion (60) or the like is provided, and its output is connected to the source of transistor P2. As a result, in addition to the same advantages as those of the preceding examples, this example also has the following feature: with booster circuit portion (60) or the like being provided separately from conventional booster circuit portion (24), transistor BN1 can be controlled independently through transistor P2; hence, the circuit operation can be controlled appropriately.

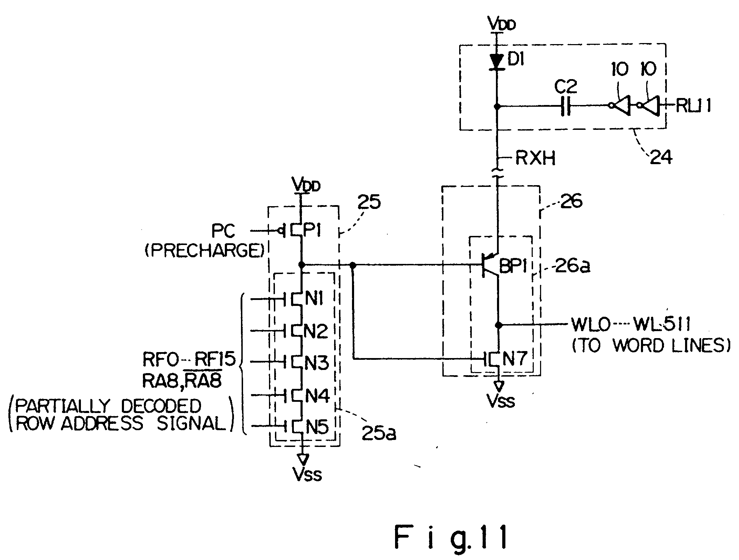

Figure 11 illustrates yet another example of this invention. In this example, instead of NPN bipolar transistor BN1 as in the preceding examples, a PNP bipolar transistor BP1 is provided. That is, the emitter of PNP bipolar transistor BP1 is connected to signal RXH; its collector is connected to the drain of N-channel MOS transistor $N_7$ and word lines (WL0-WL511); and the base of transistor BP1 is connected to the drain of P-channel MOS transistor P1 and the gate of N-channel MOS transistor N7. In this example, as PNP bipolar transistor BP1 is used in circuit block (26a) in word line driving circuit portion (26), there is no need to provide circuit block (25b) (inverter circuit) in X decoder portion (25) as in the aforementioned examples for performing the operation.

Now, with regard to the operation of the circuit in the example shown in Figure 11, first, in the precharge state (i. e., when level "0" is input to the gate of P-channel MOS transistor P1), level "1" is input to the base of PNP bipolar transistor BP1 and the gate of N-channel MOS transistor N7 from power supply voltage $V_{DD}$ through P-channel MOS transistor P1; hence, transistor BP1 is in the OFF state, while transistor N7 is in the ON state. As a result, word lines (WL0-WL511) are at level "0." Then, in the operation state, due to the selection signal of signals RF0-RF15, RA8, and $\overline{RA8}$, as in the preceding examples, level "0" is input to the gates of transistors N1-N5 in X decoder portion (25); hence, the base of PNP bipolar transistor BP1 and the gate of N-channel MOS transistor N7 are at level "0." Hence, in this state, the predetermined voltage is supplied to the selected word line (for example, WL0) by signal RXH. As a result, this example also has the same advantages as in the preceding examples.

Although the invention has been illustrated hereinabove with embodiments, the above embodiments may be further modified based on the technical idea of the invention.

For example, a lateral NPN (or PNP) bipolar transistor may also be used, although a vertical type is used as a bipolar switching element in the above examples. Besides, other appropriate elements, such as resistors, etc. may also be provided. In addition, the connections of the elements may also be variously modified.

Furthermore, the circuit configurations of X decoder portion (25), word line driving circuit portion (26), booster circuit portion (24), etc., are not limited to the aforementioned examples. Other suitable circuit configurations and circuit forms may also be used.

The examples in which the invention is applied to a 1 M dynamic RAM have been described hereinabove, but the invention may also be applied to a 2 M dynamic RAM or the like, as well as to various devices such as a static RAM or the like.

Effects of the Invention

As explained above, according to this invention, a bipolar switching element is provided on the voltage supply circuit portion side of the driving signal output circuit portion; by an operation signal, the bipolar switching element outputs the voltage of the voltage supply circuit portion as a driving signal to the output line. Thus, in this configuration, the bipolar switching element can be preset to the state enabling output of the driving signal, and there is no need for controlling the timing or the like which is needed in the conventional case in which an MOS transistor is used as the switching element of the driving circuit. As a result, the time needed for controlling the timing or the like can be shortened.

Besides, as pointed out above, as a bipolar switching element is provided on the voltage supply circuit portion side of the driving signal output circuit portion, due to the high-speed operation ability of the bipolar switching element itself, the time can be more effectively shortened. Hence, this invention provides a driving circuit that can output the predetermined driving signal to the output line in a short time.

Claims

1. A driving circuit comprising:

an operation signal supply circuit (25) for receiving an input signal and having an output to provide an operation signal as an output signal,
a power supply source from which a first predetermined voltage ($V_{DD}$) is provided as an output,
a booster circuit (24) for providing a second predetermined voltage (RXH) higher than said first predetermined voltage as an output,

a driving signal output circuit (26) respectively connected to the outputs of said operation signal supply circuit and said booster circuit, said driving signal output circuit including series connected first and second transistors (BP1, N7) having respective control gates, said first and second transistors being operated in a fashion such that the one thereof is conductive when the other thereof is non-conductive,

the output of said operation signal supply circuit being connected to the control gates of said first and second transistors,

an output line (WL0) connected to a node located between said first and second transistors,

a control MOS transistor (P1) interposed in the connection between said power supply source and said operation signal supply circuit, said control MOS transistor having source and drain regions and a gate electrode, and

said control MOS transistor being responsive to a precharged signal (PC) applied to the gate electrode thereof for transmitting said first predetermined voltage from said power supply source to the control gates of said first and second transistors included in said driving signal output circuit;

characterized in that said first and second transistors of said driving signal output circuit (26) are respectively

a bipolar transistor (BP1) as the first transistor and having base, collector and emitter electrodes,

an MOS transistor (N7) as the second transistor and having source and drain regions and a gate electrode,

one of the collector electrode and the emitter electrode of said bipolar transistor (BP1) being connected to one of the source region and the drain region of said MOS transistor,

the other of the collector electrode and the emitter electrode of said bipolar transistor being connected to the output of said booster circuit,

the other of the source region and the drain region of said MOS transistor being connected to a reference potential ($V_{SS}$),

said bipolar transistor (BP1) when conductive transmitting said second predetermined voltage (RXH) as provided by said booster circuit (24) less the voltage drop across the conductive bipolar transistor to said output line (WL0...) as a boosted drive voltage higher than said first predetermined voltage ($V_{DD}$) provided by said power supply source, while said MOS transistor (N7) is non-conductive, and

said bipolar transistor (BP1) when non-conductive preventing the application of the output of said booster circuit to said output line, while said MOS transistor (N7) is conductive for connection to the reference potential.

2. A driving circuit according to Claim 1, wherein said operation signal supply circuit includes an inverter control circuit (25b) as the output thereof connected to the control gate of said MOS transistor; further characterized in that said inverter control circuit is connected to the base electrode of said bipolar transistor (BN1),

said power supply source being connected to the input of said inverter control circuit and to the gate electrode of said MOS transistor (N7) included in said driving signal output circuit,

the output of said booster circuit being connected to the power supply input of said inverter control circuit and being provided as the output of said inverter control circuit for application to the base electrode of said bipolar transistor (BN1) to render said bipolar transistor conductive in response to actuation of said inverter control circuit in one of two operating states and to render said bipolar transistor non-conductive in the other of two operating states.

3. A driving circuit as set forth in Claim 2, further characterized by an isolation MOS transistor (N8 - Fig. 9) included in said operation signal supply circuit for receiving the input signal and connected to the input of said inverter control circuit (25b) and to the gate electrode of said MOS transistor (N7) included in said driving signal output circuit, said isolation MOS transistor having source and drain regions and a gate electrode,

said power supply source ($V_{DD}$) being connected to the gate electrode of said isolation MOS transistor,

the application of said first predetermined voltage from said power supply source to the gate electrode of said isolation MOS transistor enabling a primary voltage to be applied to the input of said inverter control circuit and to the gate electrode of said MOS transistor (N7) included in said driving signal output circuit.

4. A driving circuit as set forth in Claim 3, further characterized in that said booster circuit (24) includes inverter means (10, 10) and a first capacitor (C2) connected in series,

said inverter means and said first capacitor of said booster circuit being connected to an output line from said power supply source,

a second capacitor (C3) connected between said first capacitor and said inverter means of said booster circuit and to the input of said inverter control circuit and the gate electrode of said MOS transistor included in said driving signal output circuit,

and

said booster circuit (24) and said second capacitor (C3) in the unselected state adding to the primary voltage applied to the input of said inverter control circuit to provide an increased voltage actuating said inverter control circuit in the other of two operating states to prevent the application of the output of said booster circuit as the output of said inverter control circuit to the base electrode of said bipolar transistor to render said bipolar transistor non-conductive and to the gate electrode of said MOS transistor included in said driving signal output circuit to render said MOS transistor conductive for connection to the reference potential.

5. A driving circuit according to any of Claims 2-4, wherein said inverter control circuit comprises first and second MOS transistors (P2, N6) of opposite channel polarities and respectively having source and drain regions and a gate electrode

further characterized in that one of the source and drain regions of said first MOS transistor (P2) included in said inverter control circuit is connected to the output (RXH) of said booster circuit.

6. A driving circuit according to any of claims 2-5, further characterized in that said bipolar transistor of said driving signal output circuit is an NPN transistor (PN1),

said MOS transistor of said driving signal output circuit is an N-channel MOS transistor (N7),

the emitter electrode of said NPN bipolar transistor being connected to the drain region of said N-channel MOS transistor of said driving signal output circuit,

the collector electrode of said NPN bipolar transistor being connected to the output (RXH) of said booster circuit (24), and

the source region of said N-channel MOS transistor of said driving signal output circuit being connected to the reference potential ($V_{SS}$).

7. A driving circuit according to Claim 1, further characterized in that said bipolar transistor of said driving signal output circuit (26) is a PNP bipolar transistor (BP1), and

said MOS transistor of said driving signal output cirucit is an N-channel MOS transistor (N7),

the collector electrode of said PNP bipolar transistor being connected to the drain region of said N-channel MOS transistor,

the emitter electrode of said PNP bipolar transistor being connected to the output of said booster circuit,

the source region of said N-channel MOS transistor being connected to a reference potential ($V_{SS}$),

the application of said first predetermined voltage from said power supply source to the base electrode of said PNP bipolar transistor rendering said PNP bipolar transistor non-conductive and to the gate electrode of said N-channel MOS transistor included in said driving signal output circuit rendering said MOS transistor conductive for connection to the reference potential, and

said PNP bipolar transistor being rendered conductive in the absence of said first predetermined voltage from said power voltage source being applied to the base electrode thereof to transmit said second predetermined voltage as provided by said booster circuit less the voltage drop across the conductive bipolar transistor to said output line as a boosted drive voltage higher than said first predetermined voltage provided by said power supply source.

8. A driving circuit according to either Claim 2 or Claim 6, further characterized by a second booster circuit (60) for providing a predetermined voltage as an output, said second booster circuit being connected to the power supply input of the inverter control circuit (25b) of said operation signal supply circuit for providing the output of said second booster circuit as the output of said inverter control circuit for application to the base electrode of said bipolar transistor (BN1) to render said bipolar transistor conductive in response to actuation of said inverter control circuit in one of two operating states, and

the application of said first predetermined voltage from said power supply source to said inverter control circuit actuating said inverter control circuit in the other of two operating states to prevent the application of the output of said second booster circuit as the output of said inverter control circuit to the base electrode of said bipolar transistor (BN1) to render said bipolar transistor non-conductive and to the gate electrode of said MOS transistor included in said driving signal output circuit rendering said MOS transistor conductive for connection to the reference potential ($V_{SS}$).

**9.** A driving circuit according to Claim 8, further characterized in that one of the source and drain regions of said first MOS transistor (P2) included in said inverter control circuit (25b) is connected to the output of said second booster circuit (60), and

the other of said source and drain regions of said first MOS transistor included in said inverter control circuit being connected to the corresponding other region of said second MOS transistor (N6) included in said inverter control circuit.


**Patentansprüche**

**1.** Treiberschaltung, mit:

einer Operationssignal-Speiseschaltung (25), die ein Eingangssignal empfängt und einen Ausgang besitzt, der als Ausgangssignal ein Operationssignal bereitstellt,

einer Leistungsversorgungsquelle, von der eine erste vorgegebene Spannung ($V_{DD}$) als ein Ausgang bereitgestellt wird,

einer Spannungserhöhungsschaltung (24), die als einen Ausgang eine zweite vorgegebene Spannung (RXH) bereitstellt, die höher als die erste vorgegebene Spannung ist,

einer Treibersignal-Ausgangsschaltung (26), die an die Ausgänge der Operationssignal-Speiseschaltung bzw. der Spannungserhöhungsschaltung angeschlossen ist und in Serie geschaltete erste und zweite Transistoren (BP1, N7) mit entsprechenden Steuergates enthält, wobei die ersten und zweiten Transistoren in der Weise betrieben werden, daß einer von ihnen leitend ist, wenn der andere von ihnen nichtleitend ist,

wobei der Ausgang der Operationssignal-Speiseschaltung an die Steuergates der ersten und zweiten Transistoren angeschlossen ist,

einer Ausgangsleitung ($WL_0$), die an einen zwischen dem ersten und dem zweiten Transistor befindlichen Knoten angeschlossen ist,

einem Steuer-MOS-Transistor (P1), der in die Verbindung zwischen der Leistungsversorgungsquelle und der Operationssignal-Speiseschaltung geschaltet ist und Source- und Drain-Bereiche sowie eine Gate-Elektrode besitzt, und

wobei der Steuer-MOS-Transistor auf ein Vorladungssignal (PC) anspricht, das an seine Gate-Elektrode angelegt wird, um die erste vorgegebene Spannung von der Leistungsversorgungsquelle an die Steuergates der ersten und zweiten Transistoren, die in der Treibersignal-Ausgangsschaltung enthalten sind, zu übertragen;

dadurch gekennzeichnet, daß die ersten und zweiten Transistoren der Treibersignal-Ausgangsschaltung (26)

ein Bipolartransistor (BP1), der den ersten Transistor bildet und Basis-, Kollektor- und Emitter-Elektroden besitzt, bzw.

ein MOS-Transistor (N7), der den zweiten Transistor bildet und Source- und Drain-Bereiche sowie eine Gate-Elektrode besitzt, sind,

wobei entweder die Kollektor-Elektrode oder die Emitter-Elektrode des Bipolartransistors (BP1) entweder an den Source-Bereich oder an den Drain-Bereich des MOS-Transistors (N7) angeschlossen ist,

die andere der Kollektor- und Emitter-Elektroden des Bipolartransistors an den Ausgang der Spannungserhöhungsschaltung angeschlossen ist,

der andere der Source- und Drain-Bereiche des MOS-Transistors an ein Referenzpotential ($V_{SS}$) angeschlossen ist,

wobei der Bipolartransistor (BP1) dann, wenn er leitend ist, die zweite vorgegebene Spannung (RXH), die von der Spannungserhöhungsschaltung (24) bereitgestellt wird, abzüglich des Spannungsabfalls über dem leitenden Bipolartransistor an die Ausgangsleitung ($WL_0$ ...) als erhöhte Treiberspannung überträgt, die höher als die erste vorgegebene Spannung ($V_{DD}$) ist, welche von der Leistungsversorgungsquelle bei nichtleitendem MOS-Transistor (N7) bereitgestellt wird, und

wobei der Bipolartransistor (BP1) dann, wenn er nichtleitend ist, das Anlegen des Ausgangs der Spannungserhöhungsschaltung an die Ausgangsleitung verhindert, wenn der MOS-Transistor (N7) leitend ist, um einen Anschluß an des Referenzpotential zu schaffen.

**2.** Treiberschaltung nach Anspruch 1, in der die Operationssignal-Speiseschaltung als ihren Ausgang eine Inverter-Steuerschaltung (25b) enthält, die an das Steuergate des MOS-Transistors angeschlossen ist; ferner dadurch gekennzeichnet, daß die Inverter-Steuerschaltung an die Basis-Elektrode des Bipolartransistors (BN1) angeschlossen ist,

wobei die Leistungsversorgungsquelle an den Eingang der Inverter-Steuerschaltung und an die Gate-Elektrode des in der Treibersignal-Ausgangsschaltung enthaltenen MOS-Transistors (N7) angeschlossen ist, wobei der Ausgang der Spannungserhöhungsschaltung an den Leistungsversorgungseingang der Inverter-Steuerschaltung angeschlossen ist und als Ausgang der Inverter-Steuerschaltung vorgesehen ist, um deren Ausgangssignale an die Basis-Elektrode des Bipolartransistors (BN1) anzulegen, um den Bipolartransistor als Antwort auf die Versetzung der Inverter-Steuerschaltung in einen von zwei Betriebszuständen leitend zu machen und um den Bipolartransistor im anderen der zwei Betriebszustände nichtleitend zu machen.

3. Treiberschaltung nach Anspruch 2, ferner gekennzeichnet durch einen Trenn-MOS-Transistor (N8 - Fig. 9), der zwischen die Operationssignal-Speiseschaltung einerseits und den Eingang der Inverter-Steuerschaltung (25b) und die Gate-Elektrode des in der Treibersignal-Ausgangsschaltung enthaltenen MOS-Transistors (N7) andererseits geschaltet ist, wobei der Trenn-MOS-Transistor Source- und Drain-Bereiche sowie eine Gate-Elektrode besitzt,

wobei die Leistungsversorgungsquelle ($V_{DD}$) an die Gate-Elektrode des Trenn-MOS-Transistors angeschlossen ist, wobei das Anlegen der ersten vorgegebenen Spannung von der Leistungsversorgungsquelle an die Gate-Elektrode des Trenn-MOS-Transistors ermöglicht, eine Primärspannung an den Eingang der Inverter-Steuerschaltung und an die Gate-Elektrode des in der Treibersignal-Ausgangsschaltung enthaltenen MOS-Transistors (N7) anzulegen.

4. Treiberschaltung nach Anspruch 3, ferner dadurch gekennzeichnet, daß die Spannungserhöhungsschaltung (24) eine Invertereinrichtung (10, 10) und einen ersten Kondensator (C2), die in Serie geschaltet sind,

wobei die Invertereinrichtung und der erste Kondensator der Spannungserhöhungsschaltung an eine Ausgangsleitung von der Leistungsversorgungsquelle angeschlossen sind, und einen zweiten Kondensator (C3), der zwischen den ersten Kondensator und die Invertereinrichtung der Spannungserhöhungsschaltung geschaltet ist und an den Eingang der Inverter-Steuerschaltung sowie an die Gate-Elektrode des in der Treibersignal-Ausgangsschaltung enthaltenen MOS-Transistors angeschlossen ist, enthält, wobei die Spannungserhöhungsschaltung (24) und der zweite Kondensator (C3) im nicht gewählten Zustand zur Primärspannung, die an den Eingang der Inverter-Steuerschaltung angelegt wird, eine Spannung addieren, um eine erhöhte Spannung zu erzeugen, die die Inverter-Steuerschaltung in den anderen der zwei Betriebszustände versetzt, um das Anlegen des Ausgangs der Spannungserhöhungsschaltung als Ausgang der Inverter-Steuerschaltung an die Basis-Elektrode des Bipolartransistors zu verhindern, um den Bipolartransistor nichtleitend zu machen, und um das Anlegen des Ausgangs der Spannungserhöhungsschaltung als Ausgang der Inverter-Steuerschaltung an die Gate-Elektrode des in der Treibersignal-Ausgangsschaltung enthaltenen MOS-Transistors zu verhindern, um den MOS-Transistor für einen Anschluß an das Referenzpotential leitend zu machen.

5. Treiberschaltung nach irgendeinem der Ansprüche 2-4, in der die Inverter-Steuerschaltung erste und zweite MOS-Transistoren (P2, N6) mit entgegengesetzten Kanalpolaritäten aufweist, die jeweils Source- und Drain-Bereiche sowie eine Gate-Elektrode besitzen, ferner dadurch gekennzeichnet, daß einer der Source- und Drain-Bereiche des ersten MOS-Transistors (P2), der in der Inverter-Steuerschaltung enthalten ist, an den Ausgang (RXH) der Spannungserhöhungsschaltung angeschlossen ist.

6. Treiberschaltung nach irgendeinem der Ansprüche 2-5, ferner dadurch gekennzeichnet, daß der Bipolartransistor der Treibersignal-Ausgangsschaltung ein NPN-Transistor (PN1) ist,

der MOS-Transistor der Treibersignal-Ausgangsschaltung ein N-Kanal-MOS-Transistor (N7) ist, die Emitter-Elektrode des NPN-Bipolartransistors an den Drain-Bereich des N-Kanal-MOS-Transistors der Treibersignal-Ausgangsschaltung angeschlossen ist, die Kollektor-Elektrode des NPN-Bipolartransistors an den Ausgang (RXH) der Spannungserhöhungsschaltung (24) angeschlossen ist und der Source-Bereich des N-Kanal-MOS-Transistors der Treibersignal-Ausgangsschaltung an das Referenzpo-

EP 0 405 812 B1

tential ($V_{SS}$) angeschlossen ist.

**7.** Treiberschaltung nach Anspruch 1, ferner dadurch gekennzeichnet, daß der Bipolartransistor der Treibersignal-Ausgangsschaltung (26) ein PNP-Bipolartransistor (BP1) ist und

der MOS-Transistor der Treibersignal-Ausgangsschaltung ein N-Kanal-MOS-Transistor (N7) ist,
wobei die Kollektor-Elektrode des PNP-Bipolartransistors an den Drain-Bereich des N-Kanal-MOS-Transistors angeschlossen ist,
die Emitter-Elektrode des PNP-Bipolartransistors an den Ausgang der Spannungserhöhungsschaltung angeschlossen ist,
der Source-Bereich des N-Kanal-MOS-Transistors an ein Referenzpotential ($V_{SS}$) angeschlossen ist,
wobei das Anlegen der ersten vorgegebenen Spannung von der Leistungsversorgungsquelle an die Basis-Elektrode des PNP-Bipolartransistors den PNP-Bipolartransistor nichtleitend macht und das Anlegen dieser Spannung an die Gate-Elektrode des in der Treibersignal-Ausgangsschaltung enthaltenen N-Kanal-MOS-Transistors den MOS-Transistor für den Anschluß an das Referenzpotential leitend macht, und
wobei der PNP-Bipolartransistor bei einem Fehlen der ersten vorgegebenen Spannung von der Leistungsversorgungsquelle, die an seine Basis-Elektrode angelegt wird, leitend gemacht wird, um die zweite vorgegebene Spannung, die von der Spannungserhöhungsschaltung bereitgestellt wird, abzüglich des Spannungsabfalls über dem leitenden Bipolartransistor an die Ausgangsleitung als erhöhte Treiberspannung zu übertragen, die höher als die von der Leistungsversorgungsquelle bereitgestellte erste vorgegebene Spannung ist.

**8.** Treiberschaltung entweder nach Anspruch 2 oder nach Anspruch 6, ferner gekennzeichnet durch eine zweite Spannungserhöhungsschaltung (60), die eine vorgegebene Spannung als Ausgang bereitstellt und an den Leistungsversorgungseingang der Inverter-Steuerschaltung (25b) der Operationssignal-Speiseschaltung angeschlossen ist, um den Ausgang der zweiten Spannungserhöhungsschaltung als Ausgang der Inverter-Steuerschaltung bereitzustellen, um ihn an die Basis-Elektrode des Bipolartransistors (BN1) anzulegen, um ihn als Antwort auf die Versetzung der Inverter-Steuerschaltung in einen von zwei Betriebszuständen leitend zu machen, und
wobei das Anlegen der ersten vorgegebenen Spannung von der Leistungsversorgungsquelle an die Inverter-Steuerschaltung die Inverter-Steuerschaltung in den anderen der zwei Betriebszustände versetzt, um das Anlegen des Ausgangs der zweiten Spannungserhöhungsschaltung als Ausgang der Inverter-Steuerschaltung an die Basis-Elektrode des Bipolartransistors (BN1) zu verhindern, um den Bipolartransistor nichtleitend zu machen, und um das Anlegen des Ausgangs der zweiten Spannungserhöhungsschaltung als Ausgang der Inverter-Steuerschaltung an die Gate-Elektrode des in der Treibersignal-Ausgangsschaltung enthaltenen MOS-Transistors zu verhindern, um den MOS-Transistor für den Anschluß an das Referenzpotential ($V_{SS}$) leitend zu machen.

**9.** Treiberschaltung nach Anspruch 8, ferner dadurch gekennzeichnet, daß entweder der Source-Bereich oder der Drain-Bereich des in der Inverter-Steuerschaltung (25b) enthaltenen ersten MOS-Transistors (P2) an den Ausgang der zweiten Spannungserhöhungsschaltung (60) angeschlossen ist und
der andere der Source- und Drain-Bereiche des in der Inverter-Steuerschaltung enthaltenen ersten MOS-Transistors an den entsprechenden anderen Bereich des in der Inverter-Steuerschaltung enthaltenen zweiten MOS-Transistors (N6) angeschlossen ist.

## Revendications

**1.** Circuit de commande comprenant :

un circuit (25) de délivrance d'un signal de fonctionnement servant à recevoir un signal d'entrée et possédant une sortie pour délivrer un signal de fonctionnement en tant que signal de sortie,
une source d'alimentation en énergie, dont une première tension prédéterminée ($V_{DD}$) est délivrée en tant que signal de sortie,
un circuit survolteur (24) pour produire une seconde tension prédéterminée (RXH) supérieure à ladite première tension prédéterminée en tant que signal de sortie,
un circuit (26) de sortie d'un signal de commande connecté respectivement aux sorties dudit circuit de délivrance du signal de fonctionnement et dudit circuit survolteur, ledit circuit de délivrance du signal de commande comprenant des premier et second transistors (BP1, N7) branchés en série et comportant des grilles de commande respectives, lesdits premier et second transistors étant actionnés de telle sorte que l'un d'eux est conducteur lorsque l'autre est non conducteur,

la sortie dudit circuit de délivrance du signal de fonctionnement étant connectée aux grilles de commande dudit premier et second transistors,

une ligne de sortie (WLo) connectée à un noeud situé entre lesdits premier et second transistors,

un transistor MOS de commande (P1) intercalé dans la connexion entre ladite source d'alimentation en énergie et ledit circuit de délivrance du signal de fonctionnement, ledit transistor MOS de commande comportant des régions de source et de drain et une électrode de grille, et

ledit transistor MOS de commande étant apte à répondre à un signal préchargé (PC) appliqué à l'électrode de grille de ce transistor pour transmettre ladite première tension prédéterminée depuis ladite source d'alimentation en énergie aux grilles de commande desdits premier et second transistors contenus dans ledit circuit de sortie du signal de commande;

caractérisé en ce que lesdits premier et second transistors dudit circuit (26) de sortie du signal de commande sont respectivement

un transistor bipolaire (BP1) en tant que premier transistor et comportant des électrodes de base, de collecteur et d'émetteur, un transistor MOS (N7) en tant que second transistor et comportant des régions de source et de drain et une électrode de grille,

l'électrode de collecteur ou l'électrode d'émetteur dudit transistor bipolaire (BP1) étant connecté à la région de source ou à la région de drain dudit transistor (N7),

l'autre de l'électrode de collecteur et de l'électrode émetteur dudit transistor bipolaire étant connectée à la sortie dudit circuit survolteur,

l'autre de la région de source et de la région de drain dudit transistor MOS étant connectée à un potentiel de référence ($V_{SS}$),

ledit transistor bipolaire (BP1) transmettant, lorsqu'il est conducteur, ladite seconde tension prédéterminée (RXH) telle qu'elle est délivrée par ledit circuit survolteur (24), moins la chute de tension aux bornes du transistor bipolaire conducteur, à ladite ligne de sortie (WL0...) en tant que tension de commande amplifiée supérieure à ladite première tension prédéterminée ($V_{DD}$) délivrée par ladite source d'alimentation en énergie, tandis que ledit transistor MOS (N7) est non conducteur, et

ledit transistor bipolaire (BP1) empêchant, lorsqu'il est non conducteur, l'application du signal de sortie dudit circuit survolteur à ladite ligne de sortie, alors que ledit transistor MOS (N7) est conducteur pour établir la connexion avec le potentiel de référence.

2. Circuit de commande selon la revendication 1, dans lequel ledit circuit de délivrance du signal de fonctionnement contient un circuit de commande inverseur (25b) en tant que sortie connectée à la grille de commande dudit transistor MOS; caractérisé en outre en ce que ledit circuit de commande inverseur est connecté à l'électrode de base dudit transistor bipolaire (BN1), ladite source d'alimentation en énergie étant connectée à l'entrée dudit circuit de commande inverseur et à l'électrode de grille dudit transistor MOS (N7) contenu dans ledit circuit de sortie du signal de commande, la sortie dudit circuit survolteur étant connectée au circuit d'alimentation en énergie dudit circuit de commande inverseur et étant prévue en tant que signal de sortie dudit circuit de commande inverseur pour son application à l'électrode de base dudit transistor bipolaire (BN1) pour placer ledit transistor bipolaire à l'état conducteur en réponse à l'actionnement dudit circuit de commande inverseur dans l'un des deux états de fonctionnement et rendre ledit transistor bipolaire non conducteur dans l'autre des deux états de fonctionnement.

3. Circuit de commande selon la revendication 2, caractérisé en outre par un transistor MOS d'isolation (N8 - figure 9) connecté entre d'une part ledit circuit de délivrance du signal de fonctionnement et, d'autre part, l'entrée dudit circuit de commande inverseur (25b) et l'électrode de grille dudit transistor MOS (N7) inclus dans ledit circuit de sortie du signal de commande, ledit transistor MOS d'isolation comportant des régions de source et de drain et une électrode de grille;

ladite source d'alimentation ($V_{DD}$) étant connectée à l'électrode de grille dudit transistor MOS d'isolation, l'application de ladite première tension prédéterminée par ladite source d'alimentation en énergie à l'électrode de grille dudit transistor MOS d'isolation permettant l'application d'une tension primaire à l'entrée dudit circuit de commande inverseur et à l'électrode de grille dudit transistor MOS (N7) contenu dans ledit circuit de sortie du signal de commande.

4. Circuit de commande selon la revendication 3, caractérisé en outre en ce que ledit circuit survolteur (24) contient des moyens inverseurs (10,10) et un premier condensateur (C2) branchés en série,

lesdits moyens inverseurs et ledit premier condensateur dudit circuit survolteur étant connectés à une ligne de sortie partant de la source d'alimentation en énergie,

un second condensateur (C3) connecté entre ledit premier condensateur et lesdits moyens inverseurs dudit circuit survolteur et à l'entrée dudit circuit de commande inverseur et à l'électrode de grille dudit transistor MOS contenu dans ledit circuit de sortie du signal de commande, et

ledit circuit survolteur (24) et ledit second condensateur (C3) dans l'état non sélectionné augmentant la tension primaire appliquée à l'entrée dudit circuit de commande inverseur pour produire une tension accrue plaçant ledit circuit de commande inverseur dans l'autre des deux états de fonctionnement pour empêcher l'application du signal de sortie dudit circuit survolteur en tant que signal de sortie dudit circuit de commande inverseur à l'électrode de base dudit transistor bipolaire pour rendre non conducteur ledit transistor bipolaire, et à l'électrode de grille dudit transistor MOS contenu dans ledit circuit de sortie du signal de commande pour rendre conducteur ledit transistor MOS pour le raccordement au potentiel de référence.

5. Circuit de commande selon l'une quelconque des revendications 2-4, dans lequel ledit circuit de commande inverseur comprend des premier et second transistors MOS (P2,N6) dont les canaux ont des polarités opposées et qui comportent respectivement des régions de source de drain et une électrode de grille,

caractérisé en outre en ce que l'une des régions de source et de drain dudit premier transistor MOS (P2) contenu dans ledit circuit de commande inverseur est connectée à la sortie (RXH) dudit circuit survolteur.

6. Circuit de commande selon l'une quelconque des revendications 2-5, caractérisé en outre en ce que ledit transistor bipolaire dudit circuit de sortie du signal de commande est un transistor NPN (PN1),

que ledit transistor MOS dudit circuit de sortie du signal de commande est un transistor MOS à canal N (N7), que l'électrode d'émetteur dudit transistor bipolaire NPN est connectée à la région de drain du transistor à canal N dudit circuit de sortie du signal de commande,

l'électrode de collecteur dudit transistor bipolaire NPN étant connectée à la sortie (RXH) dudit circuit survolteur (24), et

la région de source dudit transistor MOS à canal N dudit circuit de sortie du signal de commande étant connectée au potentiel de référence ($V_{SS}$).

7. Circuit de commande selon la revendication 1, caractérisé en outre en ce que ledit transistor bipolaire dudit circuit (26) de sortie du signal de commande est un transistor bipolaire PNP (BP1), et

que ledit transistor MOS dudit circuit de sortie du signal de commande est un transistor MOS à canal N (N7), l'électrode de collecteur dudit transistor bipolaire PNP étant connectée à la région de drain dudit transistor MOSFET à canal N,

l'électrode d'émetteur du transistor bipolaire PNP étant connectée à la sortie dudit circuit survolteur, la région de source dudit transistor MOS à canal N étant connectée à un potentiel de référence ($V_{SS}$), l'application de ladite première tension prédéterminée délivrée par ladite source d'alimentation en énergie à l'électrode de base dudit transistor bipolaire PNP rendant non conducteur ledit transistor bipolaire PNP, et l'application de ladite première tension prédéterminée délivrée par la source d'alimentation en énergie à l'électrode de grille dudit transistor MOS à canal N contenu dans ledit circuit de sortie du signal de commande rendant conducteur ledit transistor MOS pour le raccordement au potentiel de référence, et

ledit transistor PNP étant rendu conducteur en l'absence de l'application de ladite première tension prédéterminée délivrée par ladite source de tension d'alimentation à l'électrode de base de ce transistor pour transmettre ladite seconde tension prédéterminée, telle qu'elle est fournie par le circuit survolteur, moins la chute de tension aux bornes du transistor bipolaire conducteur, à ladite ligne de sortie en tant que tension de commande amplifiée supérieure à ladite première tension prédéterminée délivrée par ladite source d'alimentation en énergie.

8. Circuit de commande selon la revendication 2 ou la revendication 6, caractérisé en outre par un second circuit survolteur (60) servant à délivrer une tension prédéterminée en tant que signal de sortie, ledit second circuit survolteur étant connecté à l'entrée d'alimentation en énergie du circuit de commande inverseur (25b) dudit circuit de délivrance du signal de fonctionnement pour délivrer le signal de sortie dudit second circuit survolteur en tant que signal de sortie dudit circuit de commande inverseur pour son application à l'électrode de base dudit transistor bipolaire (BN1) pour rendre conducteur ledit transistor bipolaire en réponse à l'actionnement dudit circuit de commande inverseur dans l'un de deux états de fonctionnement, et

l'application de ladite première tension prédéterminée délivrée par ladite source d'alimentation en énergie audit circuit de commande inverseur plaçant ledit circuit de commande inverseur dans l'autre de deux états de fonctionnement pour empêcher l'application du signal de sortie dudit second circuit survolteur en tant que signal de sortie dudit circuit de commande inverseur à l'électrode de base dudit transistor bipolaire (BN1) pour rendre non conducteur ledit transistor bipolaire, et à l'électrode de grille du transistor MOS contenu dans ledit circuit de sortie du signal de commande, pour rendre conducteur ledit transistor MOS pour le raccordement au potentiel de référence ($V_{SS}$).

**9.** Circuit de commande selon la revendication 8, caractérisé en outre en ce que l'une des régions de source et de drain dudit premier transistor MOS (P2) contenu dans ledit circuit de commande inverseur (25b) est connectée à la sortie dudit second circuit survolteur (60), et

l'autre desdites régions de source et de drain dudit premier transistor MOS contenu dans ledit circuit de commande inverseur étant connectée à l'autre région correspondante dudit second transistor MOS (N6) contenu dans ledit circuit de commande inverseur.

24

V_DD

D1

C2    10    10

RL11

RXH

Ⓐ 25b Ⓑ

V_DD

26

PC
(PRECHARGE)

P1

P2

BN1    26a

N6

Vss

WL0 --- WL511
(TO WORD LINES)

PF0 --- PF15
RA8, RA8

N1
N2
N3
N4
N5

N7

(PARTIALLY DECODED
ROW ADDRESS SIGNAL)

25

Vss

Vss

25a

F i g. 1

Fig. 2

Fig. 3

EP 0 405 812 B1

F i g. 4

Fig. 5

VPP(RXH)

VPP(RXH)

WL

B

E

S

D

C

NPN BIPOLAR TRANSISTOR BN1

P-CHANNEL MOS TRANSISTOR P2

COLLECTOR OF NPN BIPOLAR TRANSISTOR BN1

Fig.6

Fig.7

EP 0 405 812 B1

Fig. 8

Fig. 9

F i g. 10

EP 0 405 812 B1

V_DD

D1

C2    10  10

RU1

24

RXH

V_DD

PC
(PRECHARGE)

P1

25

25

N1

N2

BP1    26a

RF0~RF15
RA8, $\overline{RA8}$

N3

WL0~WL511
(TO WORD LINES)

(PARTIALLY DECODED
ROW ADDRESS SIGNAL)

N4

N7

N5

25a

V_SS

V_SS

F i g. 11

EP 0 405 812 B1

RFO···RF3

RL21(ENABLE)

4(4a)

RXHO···RXH3

PC
(PRECHARGE)

RF4···RF15
RA8, RA8
(PARTIALLY DECODED
ROW ADDRESS SIGNAL)

WLO···WL511
(TO WORD LINES)

Fig.12

F i g. 13

EP 0 405 812 B1

Fig.14

Fig. 15

RXH3 RXH2 RXH1 RXH0

5a    6    6a

RF4 ---- RF7
RF8 ---- RF11
RF12 --- RF15
A8 , $\overline{A8}$

(PARTIALLY DECODED
ROW ADDRESS SIGNAL)

5

6a —WL0, 4 , 8 ---- 504,508
6a —WL1, 5 , 9 ---- 505,509
6a —WL2, 6 ,10 ---- 506,510
6a —WL3, 7 ,11, ----507,511

TOTAL 512 SETS

EP 0 405 812 B1

F i g.16

F i g.17